# EUROPEAN PATENT APPLICATION

(11) **EP 4 576 578 A1**
(43) Date of publication of application: **25.06.2025**
(21) Application number: 24212647.2
(22) Date of filing: 13.11.2024
(51) Int. Cl.: H03L 7/081, G06F 1/10

(54) **DIE-TO-DIE CLOCK SIGNALLING INCLUDING ADAPTIVE FREQUENCY DELAY-LOCKED LOOP**

(30) Priority: 22.12.2023 US 202318394351
(71) Applicant: INTEL Corporation, Santa Clara, CA 95054 (US)
(72) Inventor: KURD, Nasser, Portland, 97229 (US); GALAN, Andres, North Plains, 97133 (US); MOSALIKANTI, Praveen, Portland, 97229 (US); SHEN, Kuan-Yueh, Portland, 97229 (US); JAIN, Akshar, Hillsboro, 97124 (US); NEIDENGARD, Mark, Beaverton, 97006 (US); GROSSNICKLE, Vaughn, Beaverton, 97006 (US); EL-HUSSEINI, Ali, Hillsboro, 97124 (US); SYED FAROOQ, Syed Feruz, Hillsboro, 97124 (US)
(74) Representative: Viering, Jentschura & Partner mbB Patent- und Rechtsanwälte

(57) **Abstract**

Some embodiments include an apparatus having a first delay line of a delay-locked loop (DLL) circuitry, the first delay line including an input node to receive an input clock signal and delay stages coupled in series with the input node; a first multiplexer including input nodes coupled to output nodes of a portion of the delay stages; and a second delay line of the DLL circuitry including an input node coupled to an output node of the multiplexer, and delay stages coupled in series with the input node of the second delay line, the second delay line including an output node to provide an output clock signal.

## Description

### Background

Some communications between different devices in electronic systems are based on timing of a clock signal in a synchronous or asynchronous clocking system. Clock asynchronous systems often employ FIFO (First In First Out) circuitry and hand-shaking mechanisms, which can add non-trivial latencies that may be unsuitable for some (e.g., high-speed) communication systems. Thus, clock synchronous (common clocking) systems are usually favorable in electronic systems that have devices that operate at relatively at low-latency and low-power.

In some conventional systems that include die-to-die communication, clock distribution networks can have wide delay ranges (e.g., reaching hundreds of picoseconds of delay) that vary with voltage, process skew corners, and temperature. Thus, it is often a challenge to perform die-to-die clock deskew to clock signals in different devices (e.g., chiplets) of a system (e.g., 3-D chiplet system) especially devices that are formed using different process technology nodes. Another challenge of die-to-die clock deskew often involves supporting fast voltage and frequency (FGV) change, including die-to-die input/output (IO) circuitry. In a FGV change, the clock frequency may change on the fly and may move across a wide frequency range (400MHz to several GHz) while the system continues to use the clock. For example, when the clock changes between frequencies (e.g., between a minimum frequency and a maximum frequency) in a synchronous system, the clock system usually needs a mechanism to deskew different clock signals across different dies. The clock system may also track the clock without compromising the output frequency, phase error, and duty cycle.

Further, some conventional die-to-die architectures use source synchronous communication that employ several asynchronous FIFOs at transceiver circuitry. The presence of such FIFOs can add more latency to latency-sensitive data paths that may further complicate die-to-die clock deskew. Moreover, some conventional a die-to-die clock deskew solutions may involve expensive high-volume manufacturing (HVM) calibration that can incur high test time and manufacturing cost.

### Brief Description of the Drawings

FIG. 1 shows an apparatus including devices, according to some embodiments described herein.
FIG. 2 is a timing diagram showing waveform clock signals shown in FIG. 1, according to some embodiments described herein.
FIG. 3 shows a device including adaptive delay-locked loop (DLL) circuitry, according to some embodiments described herein.
FIG. 4A, FIG. 4B, and FIG. 4C show example relationships between an input clock signal and a feedback clock signal during a synchronization operation of the device of FIG. 3, according to some embodiments described herein.
FIG. 5 shows part of a delay line of FIG. 3, according to some embodiments described herein.
FIG. 6 is diagram showing an example relationship between delay and control information associated with the delay line of FIG. 3, according to some embodiments described herein.
FIG. 7 shows part of another delay line of FIG. 3, according to some embodiments described herein.
FIG. 8 shows detail of a circuit of the DLL circuitry of FIG. 3, according to some embodiments described herein.
FIG. 9 shows control circuitry associated with the DLL circuitry of FIG. 3, according to some embodiments described herein.
FIG. 10A is a flowchart showing a method of operating the device of FIG. 3, according to some embodiments described herein.
FIG. 10B shows detail of an activity of the method of FIG. 10A, according to some embodiments described herein.
FIG. 10C shows detail of another activity of the method of FIG. 10A, according to some embodiments described herein.
FIG. 11 shows a method of operating an apparatus, according to some embodiments described herein.
FIG. 12 shows an apparatus in the form of a system (e.g., electronic system), according to some embodiments described herein.

### Detailed Description

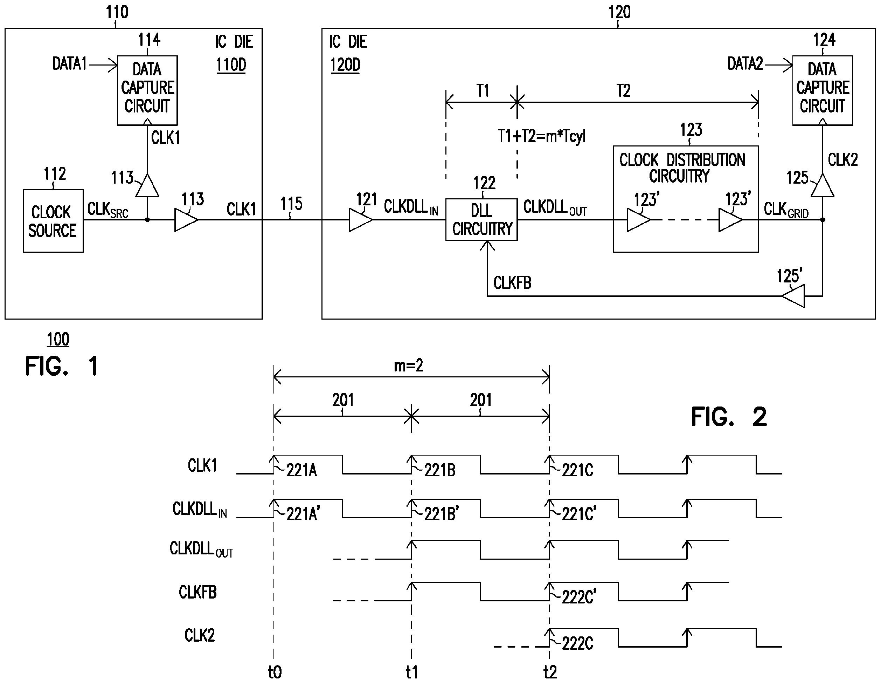

The techniques described herein provide solutions that enable synchronous clocking systems in electronic systems. Examples of such electronic systems include devices (e.g., chiplets) in 3-D chipset systems or in other integrated circuit (IC) structure. In an example, the techniques described herein involve adaptive delay-locked loop (DLL) circuitry to align (deskew) relatively long delay clock distributions across the devices (e.g., chiplets) of the system. The devices can be implemented on the same or different process technologies. The described adaptive DLL circuitry can operate to track frequency and voltage changes on the fly (FGV) while achieving target latency (e.g., lowest latency) across the communication channel between the devices (e.g., between the chiplets). The target latency can be analogous to latency of communication between different part of the same IC die. In an example, the deskew architecture, in addition to tracking FGV, can compensate for wide variable clock distribution delays due to distribution supply voltages, and temperatures without involving HVM calibration, thereby lowering die cost. The adaptive DLL circuitry can be scalable and capable of locking dynamically by calibrating the target delay cycle information "m". The described techniques allow the "m" per die to remain constant and avoid false locking to harmonics or abrupt changes to "m" during frequency transition. This can avoid large skew across the dies during operation. These and other improvements and benefits of the described techniques are discussed in more detail below with reference to FIG. 1 through FIG. 12.

FIG. 1 shows an apparatus 100 including devices 110 and 120, according to some embodiments described herein. Apparatus 100 can include or be included in an electronic device or system, such as a computer (e.g., desktop, laptop, or notebook), a tablet, a cellular phone, a system on chip (SoC), a system in a package (SiP), or other electronic devices or systems. Device 110 can include or can be included in an IC die 110D (e.g., an IC chip, such as a semiconductor chip). Device 120 can include or can be included in an IC die 120D (e.g., an IC chip, such as a semiconductor chip). Each of IC die 110D and die 120D can include a semiconductor die (e.g., silicon-based die). Devices 110 and 120 can include a combination of a controller (e.g., processors (e.g., central processing unit [CPU]), graphics controller, input/output (I/O) controller, or memory controller), a memory device, and/or other electronic devices. In an example, device 110 can include or can be included in a chiplet and device 120 can include or can be included in another chiplet. The chiplets can part of a package that includes multiple chiplets (e.g., 3-D chiplets).

As shown in FIG. 1, device 110 can include a clock source (e.g., clock generator) 112, buffer circuits (clock driver circuits) 113, and a data capture circuit 114. Clock source 112 can include circuitry to generate a clock signal CLK_{SRC}. Device 110 can provide a clock signal CLK1 based on CLK_{SRC}. Data capture circuit 114 can include a flip-flop, a register, or other type of circuits. Device 110 can use clock signal CLK1 as a timing signal to capture (receive) data information DATA1 at data capture circuit 114 based on timing of clock signal CLK1.

As shown in FIG. 1, device 110 can also send clock signal CLK1 to device 120 through a conductive path 115 coupled between devices 110 and 120. Conductive path 115 can include conductive traces on a circuit board where devices 110 and 120 are located. In an example, conductive path 115 can include conductive traces (e.g., metal-based conductive traces) of a bus on a circuit board (e.g., printed circuit board (PCB) of an electronic system).

As shown in FIG. 1, device 120 can include a buffer circuit (e.g., clock driver circuit) 121 and DLL circuitry 122. Buffer circuit 121 can receive clock signal CLK1 and provide it to DLL circuitry 122 as a clock signal CLKDLL_{IN}. DLL circuitry 122 of device 120 can generate a clock signal CLKDLL_{OUT} based on clock signal CLKDLL_{IN}.

Device 120 can include a clock distribution circuitry (e.g., clock tree) 123 and a buffer circuit (e.g., clock driver circuit) 125 to generate a clock signal CLK2 based on clock signal CLKDLL_{OUT}. Device 120 can use CLK2 as a timing signal to capture (receive) data information DATA2 at data capture circuit 124 based on timing of clock signal CLK1. Data capture circuit 124 can include a flip-flop, a register, or other type of circuits. As shown in FIG. 1, clock distribution circuitry 123 can generate a clock signal CLK_{GRID}, which can be provided (e.g., distributed) to data capture circuit 124 as clock signal CLK2.

Device 120 can also generate clock signal (e.g., feedback clock signal) CLKFB. Device 120 can also include a buffer circuit (e.g., clock driver circuit) 125'. Clock signal CLK_{GRID} from clock distribution circuitry can be provided (e.g., distributed) to DLL circuitry 122 by buffer circuit 125' as clock signal CLKFB. In an example, one or both of buffer circuits 125 and 125' can include a region clock buffer circuit, a region clock buffer circuit, or both. In an example, one or both of buffer circuits 125 and 125' can be part of clock distribution circuitry 123.

Buffer circuits 125 and 125' can have similar physical structures or the same structure such that clock signals CLK2 and CLKFB (which are generated based on the same clock signal CLK_{GRID}) can have a similar (or the same profile). DLL circuitry 122 can use clock signal CLKFB as feedback information as part of the operation to synchronize clock signals CLK1 and CLK2. The wave forms of clock signals CLK2 and CLKFB can have a similar profile (e.g., phase and frequency) such that when clock signals CLK1 and CLKFB are synchronized (or deem to be synchronized), clock signals CLK1 and CLK2 are also synchronized (or deem to be synchronized).

In FIG. 1, label T1 represents a time interval (an amount of time) applied to a clock path of a clock signal (e.g., CLKDLL_{IN}) through DLL circuitry 122. Label T2 refers to a time interval (an amount of time) applied to a clock path of a clock signal (e.g., CLKDLL_{OUT}) through clock distribution circuitry 123. Time interval T1 can be measured based on the cycle (period) of the clock signal (CLKDLL_{IN}) at the input node of DLL circuitry 122. For simplicity, time intervals T1 and T2 are sometimes called T1 and T2, respectively (without the term "time interval").

In FIG. 1, label m represents delay cycle information m (loop delay information m). For simplicity, delay cycle information m is sometimes called m (without the term "delay cycle information"). In FIG. 1, m is an integer where the value (e.g., m can be equal to 1, 2, 3, or other integers) of m can be selected based on the operating condition of device 120.

Thus, as shown in FIG. 1, the total of T1 and T2 can be equal to m multiplied by Tcycle (T1 + T2 = m * Tcycle), where Tcycle is the cycle (period) of clock signal CLK1. In an example, each of T1 and T2 (FIG. 1) can be equal to one Tcycle (e.g., one cycle of clock signal CLK1 or CLKDLL_{IN}). Thus, in this example, m = (T1 + T2) / Tcycle = 2. Delay cycle information m in association with the operation of DLL circuitry described herein is described in more detail below.

For simplicity, the clock signals described herein are sometimes called by the labels shown in the figures without the terms "clock signal" or "clock signals". For example, clock signals CLK1, CLK2, CLKDLL_{IN}, CLKDLL_{OUT}, and CLKFB are sometimes called CLK1, CLK2, CLKDLL_{IN}, CLKDLL_{OUT}, and CLKFB (without the term "clock signal" or "clock signals").

FIG. 2 is a timing diagram showing waveforms of the clock signals shown in FIG. 1, according to some embodiments described herein. As shown in FIG. 2, CLK1 has a cycle (period) 201 and edges (e.g., rising edges) 221A, 221B, and 221C. Each of CLKDLL_{IN}, CLKDLL_{OUT}, CLKFB, and CLK2 can have the same cycle as CLK1. Each of CLKDLL_{IN}, CLKDLL_{OUT}, CLKFB, and CLK2 also has rising edges (indicated by arrows in FIG. 2). For example, CLKDLL_{IN} (which has a similar waveform as CLK1) has edges (e.g., rising edges) 221A', 221B', and 221C'. CLK2 has an edge (e.g., rising edge) 222C. CLKFB (which has a similar waveform as CLK2) has an edge (e.g., rising edge) 222C'.

FIG. 2 shows times (points in time) t0, 11, and t2. Time t1 occurs after time 11. Time t2 occurs after time 11. At time t0, CLKDLL_{IN} is provided to DLL circuitry 122 (FIG. 1). Between times T0 and T2, DLL circuitry 122 (FIG. 1) can operate to synchronize CLK1 and CLK2 based on a relationship between CLKDLL_{IN} and CLKFB. FIG. 2 shows an example where CLKDLL_{IN} and CLKFB may be synchronized at time t2, which is two cycles of CLK1 counting from time t0. CLKDLL_{IN} and CLKFB are synchronized (or deemed to be synchronized) when edge 221C' of CLK1 and edge 222C' of CLKFB are aligned (e.g., aligned at time t2). The edges (e.g., rising edges) of two clock signals (CLKDLL_{IN} and CLKFB) can be determined to be aligned with each other when such edges occur within an expected (predetermined) time margin (e.g., predetermined time interval).

Since CLK1 and CLKDLL_{IN} have similar waveforms and CLK2 and CLKFB have similar waveforms, CLK1 and CLK2 are synchronized (or deemed to be synchronized) when CLKDLL_{IN} and CLKFB are synchronized (or deemed to be synchronized). For example, as shown in FIG. 2, CLK1 and CLK2 are synchronized at time t2 at which edge 221C of CLK1 and edge 222C of CLK2 are aligned at time t2.

FIG. 2 shows "m = 2" to illustrate an example where CLK1 and CLK2 may be synchronized within two cycles of CLK1. However, DLL circuitry 122 (FIG. 1) can operate, such that CLK1 and CLK2 can be synchronized within a different number of the cycle CLK1 (e.g., m can be greater than two (m > 2)).

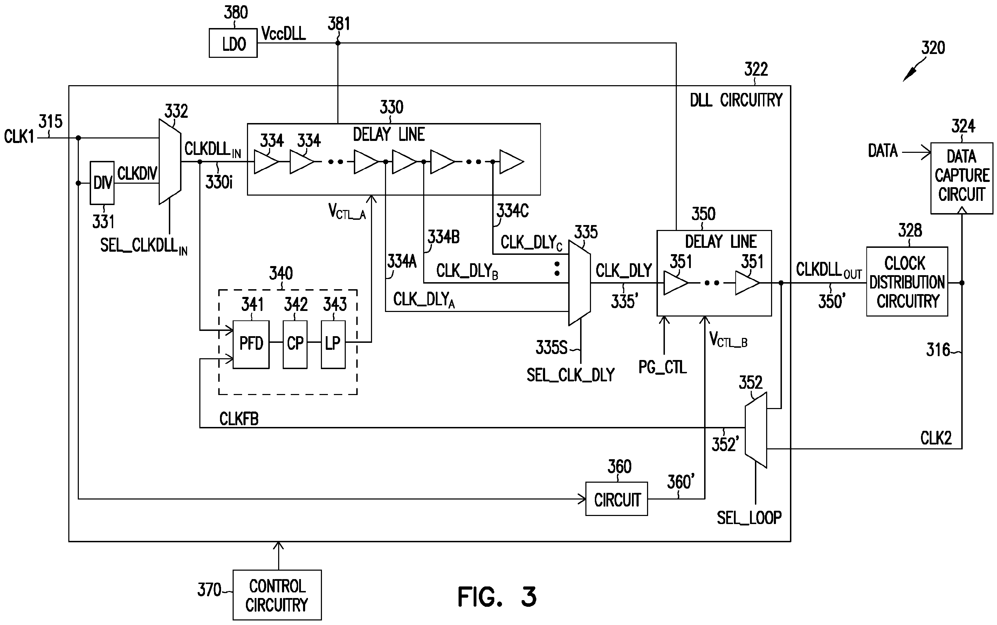

FIG. 3 shows a device 320 including DLL circuitry 322, according to some embodiments described herein. Device 320 and DLL circuitry 322 can correspond to (e.g., can represent) device 120 and DLL circuitry 122, respectively, of FIG. 1). Thus, device 320 can include an IC die like IC die 120D of device 120 of FIG. 1. As shown in FIG. 3, device 320 can include data capture circuit 324 and clock distribution circuitry 328 that can correspond to data capture circuit 124 and clock distribution circuitry 123, respectively, of FIG. 1.

Detailed operation of device 320 is described below with reference to FIG. 3 through FIG. 10C. In general, the operation of device 320, including the operation of DLL circuitry 322, is as follows. In FIG. 3, CLK1 can be provided (sent) to device 320 from an external device (e.g., device 110) different from device 320. CLK1 is at or near the end of the clock distribution in the external device. As shown in FIG. 3, CLK1 clock can be fed to DLL circuitry 322 that includes a feedback signal CLKFB provided from the end (or near the end) of clock distribution circuitry 328. After DLL circuitry 322 locks to "m" (a target number of clock cycles included in delay cycle information), CLK1 and CLK2 are synchronized (are aligned). During the initial lock state, DLL circuitry 322 can lock in an initial mode (e.g., a tight loop mode) to avoid operating in a non-linear part of the delay line. Then, after full loop (including clock distribution circuitry) is enabled in a subsequent mode (e.g., long loop mode), DLL circuitry 322 can check for the delay cycle information that allows DLL circuitry 322 to achieve a subsequent lock state in the subsequent mode. If the delay cycle information does not match "m", device 320 divides (temporarily divides) CLK1 by 2 (e.g., a predetermined value) and waits until the DLL is locked. Dividing CLK1 operation allows DLL circuitry 322 to lock to a constant delay cycle information (e.g., "m") that may vary per part because DLL circuitry 322 may have more than one cycle in the loop with long clock distribution delays. Finally, DLL circuitry 322 switches to CLK1 (the full speed clock) and remains locked by adjusting control information V_{CTL_A} and/or programmable delay, thereby tracking voltage, frequency, phase, or temperature changes. As shown in FIG. 3, DLL circuitry 322 includes a delay structure, which can include delay line 330 (analog controlled delay line) augmented by a delay line 350 (providing a delay based on the frequency of CLK1) utilizing a charge pump (in circuit 360) and a controllable number of delay stages (e.g., delay stages 351) to allow DLL circuitry 322 to avoid locking to extreme control voltages. Further, device 320 can operate to digitally convert the total delay normalized to number of cycles using counters to monitor the number of cycles in the loop of DLL circuitry 322. This allows the loop delay to be adjusted thereby achieving phase alignment to a constant m that may vary per part.

As shown in FIG. 3, device 320 can include a node (e.g., clock input node) 315 to receive CLK1, which can be sent from another device (e.g., device 110 of FIG. 1) coupled to device 320. Device 320 can include a node (e.g., clock output node) 316 to provide CLK2, which can be used to capture data information DATA at data capture circuit 324. CLK2 can be generated based on CLK1. The timing of CLK1 and CLK2 can the similar to or the same as that of FIG. 2.

As shown in FIG. 3, DLL circuitry 322 can include a frequency divider (labeled as "DIV") 331, a multiplexer (MUX) 332, a delay line 330, a multiplexer (MUX) 335, and a circuit 340. Frequency divider 331 can operate to divide the frequency of CLK1 and generate a clock signal CLKDIV, such that the frequency of CLK1 can be a multiple of the frequency of clock signal CLKDIV. For example, the frequency CLK1_freq of clock signal CLK1 and the frequency CLKDIV freq of CLKDIV of clock signal CLKDIV can be expressed as CLK1 freq = m*CLKDIV_freq.

MUX 332 can include input nodes (not labeled) to receive CLK1 and clock signal CLKDIV, respectively. MUX 332 can respond to information (e.g., select information) SEL_CLKDLL_{IN} to select one of CLK1 and CLKDIV (either CLK1 or CLKDIV) and provide the selected clock signal (either CLK1 or CLKDIV) to its output node (coupled to node 330i) as CLKDLL_{IN}.

Delay line 330 can include node (e.g., input node) 330i coupled to the output node of MUX 332 to receive CLKDLL_{IN}. Delay line 330 can include delay stages 334 coupled in series with node 330i of delay line 330. Each of delay stages 334 can provide a time delay (in time unit) based on the value (e.g., voltage value) of control information V_{CTL_A}. Delay line 330 can include control input node (or nodes) to receive control information V_{CTL_A}. Delay line 330 can provide a range of time delay based on the number (quantity) of delay stages 334 included in delay line 330. For simplicity, control information V_{CTL_A} is sometimes called V_{CTL_A} (without the term "control information").

As shown in FIG. 3, delay stages 334 can be coupled in series with each other, such that the output node of a preceding delay stage can be coupled to the input node of succeeding delay stage (e.g., succeeding delay stage). Output nodes (e.g., output nodes 334A, 334B, and 334C) of respective delay stages 334 of a portion of the total number of delay stages 334 can be coupled to input nodes (not labeled) of MUX 335. Output nodes 334A, 334B, and 334C can provide clock signals CLK_DLY_{A}, CLK_DLY_{B}, and CLK_DLY_{C}, respectively. Each of clock signals CLK_DLY_{A}, CLK _DLY_{B}, and CLK_DLY_{C} is a different delay version of clock signal CLKDLL_{IN}.

MUX 335 can operate to respond to information (e.g., select information) SEL_CLK_DLY at control input (e.g., control input node) 335S of MUX 335. Based on information SEL_CLK_DLY, MUX 335 can select one of clock signals CLK_DLY_{A}, CLK_DLY_{B}, and CLK_DLY_{C}, to be a clock signal CLK_DLY at an output node 335' of MUX 335.

Referring to FIG. 3, circuit 340 can operate to generate V_{CTL_A}, which is used to control the delay (time delay) that delay line 330 applied to CLKDLL_{IN}. As shown in FIG. 3, circuit 340 can include a phase frequency detector (PFD) 341, a charge pump (CP) 342, and a low-pass filter 343. PFD 341 can operate to provide control information to control CP 342 based on the relationship between CLKDLL_{IN} and CLKFB. CP 342 can operate to control (e.g., increase or decrease) the value (e.g., voltage value) of the voltage signal that represents V_{CTL_A}. Low-pass filter 343 can operate to improve the quality of the voltage signal that presents V_{CTL_A}.

Control information V_{CTL_A} (generated by circuit 340) can have a value (e.g., voltage value) based on the relationship (e.g., phase, frequency, or both) between CLKDLL_{IN} and CLKFB. As part of the synchronization operation to synchronize CLK1 and CLK2, circuit 340 can adjust (e.g., increase or decrease) the value of control information V_{CTL_A} based on relative positions of the edges (e.g., rising edges) of CLKDLL_{IN} and CLKFB until CLKDLL_{IN} and CLKFB are synchronized (which also mean CLK1 and CLK2 are synchronized).

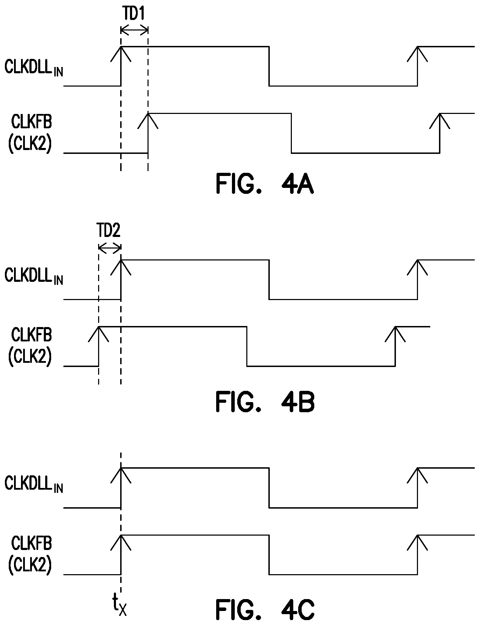

FIG. 4A, FIG. 4B, and FIG. 4C show example relationships between CLKDLL_{IN} and CLKFB during a synchronization operation to CLK1 and CLK2. FIG. 4A shows an example where the rising edge of CLKDLL_{IN} leads (occurs before) the rising edge of CLKFB by a duration (an amount of time) TD1 before CLKDLL_{IN} and CLKFB (before CLK1 and CLK2) are synchronized. FIG. 4B shows an example where the rising edge of CLKDLL_{IN} lags (occurs after) the rising edge of CLKFB by a duration (an amount of time) TD2 before CLKDLL_{IN} and CLKFB (before CLK1 and CLK2) are synchronized. FIG. 4C shows the rising edges of CLKDLL_{IN} and CLKFB are aligned at time tx. CLK1 and CKK2 can be considered to be synchronized at time TX tx (FIG. 4C).

Referring to FIG. 3, circuit 340 can operate to control (e.g., decrease, increase, or keep unchanged) the value of control information V_{CTL_A} to cause delay line 330 to apply an appropriate amount of delay (e.g., decrease, increase, or keep unchanged the amount of delay) to CLKDLL_{IN} based on the relationship between positions of the rising edges CLKDLL_{IN} and CLKFB. For example (e.g., in the example of FIG. 4A), circuit 340 can control (e.g., decrease) the value of control information V_{CTL_A} to cause delay line 330 to increase the amount of delay applied to CLKDLL_{IN} if the rising edge of CLKDLL_{IN} leads (occurs before) the rising edge of CLKFB. In another example (e.g., in the example of FIG. 4B), circuit 340 can control (e.g., increase) the value of control information V_{CTL_A} to cause delay line 330 to decrease the amount of delay applied to CLKDLL_{IN} if the rising edge of CLKDLL_{IN} lags (occurs after) the rising edge of CLKFB. In another example (e.g., in the example of FIG. 4C), circuit 340 can control (e.g., keep unchanged) the value of control information V_{CTL_A} to cause delay line 330 to keep unchanged the amount of delay applied to CLKDLL_{IN} if the rising edges of CLKDLL_{IN} and CLKFB are aligned.

As shown in FIG. 3, circuitry 322 can include a delay line 350, a multiplexer (MUX) 352, and a circuit 360. Delay line 350 can include an input node (not labeled) coupled to output node 335' of MUX 335 to receive clock signal CLK_DLY. Delay line 350 can include an output node 350' to provide clock signal CLKDLL_{OUT} (which can correspond to clock signal CLKDLL_{OUT} of FIG. 1). Delay line 350 can include control input node (or nodes) to receive control information V_{CTL_B}. Circuit 360 can operate to generate V_{CTL_B}, which is used to control the delay (time delay) that delay line 350 applies to CLK_DLY to generate CLKDLL_{OUT}. CLKDLL_{OUT} is a delay version of CLK_DLY. For simplicity, control information V_{CTL_B} is sometimes called V_{CTL_A} (without the term "control information").

MUX 352 can include input nodes (not labeled) to receive CLKDLL_{OUT} CLK2, respectively. MUX 352 can respond to information (e.g., select information) SEL_LOOP to select one of CLKDLL_{OUT} and CLK2 (either CLKDLL_{OUT} or CLK2) and provide the selected clock signal (either CLKDLL_{OUT} or CLK2) to its output node 352' as CLKFB.

As shown in FIG. 3, delay line 350 can include delay stages 351 coupled in series with output node 335' of MUX 335. Each of delay stage 351 can provide a time delay (in time unit) based on the value (e.g., voltage value) of control information V_{CTL_B} (at an output node 360' of circuit 360). Delay line 350 can provide a range of time delay based on the number (quantity) of delay stages 351 included in delay line 350.

As shown in FIG. 3, delay stages 351 can be coupled in series with each other, such that the output node of a preceding delay stage (e.g., preceding delay stage) 351 can be coupled to the input node of succeeding delay stage (e.g., succeeding delay stage) 351. The output node (not labeled) of one of delay stages 351 (e.g., the last delay stage 351 in the series of delay line 350 can be coupled to output node 350' of delay line 350 to provide clock signal CLKDLL_{OUT}.

Circuit 360 can operate to generate V_{CTL_B} at output node 360' based on the frequency of CLK1 received at node 315. The value of V_{CTL_B} can be proportional to the value of frequency CLK1_freq. Thus, the value (e.g., voltage value) of V_{CTL_B} can increase responsive to an increase in frequency CLK1_freq of CLK1. The value (e.g., voltage value) V_{CTL_B} can decrease responsive to a decrease in frequency CLK1_freq of CLK1. The amount of delay (time delay) applied to CLK_DLY can be inversely proportional to the value of V_{CTL_B}. For example, the amount of delay applied to CLK_DLY decreases when the value of V_{CTL_B} increases. In another example, the amount of delay applied to CLK_DLY increases when the value of V_{CTL_B} decreases.

As shown in FIG. 3, device 320 can include a low-dropout (LDO) voltage regulator to provide a voltage VccDLL at a supply node 381. Voltage VccDLL can be used as a supply voltage for delay line 330 and delay line 350.

In operation, frequency divider 331 can operate to divide CLK1 by loop delay information m during part of the operation of DLL circuitry 322 to prevent of DLL circuitry 322 from false locking. The value of m can be a predetermined value and can be varied by device 320 based on the frequency of CLK1, as described in more detail below.

Circuit 340 can generate V_{CTL_A} based on the relationship (e.g., phase and frequency) between CLKDLL_{IN} and CLKFB. Delay line 330 can adjust the delay applied to CLKDLL_{IN} based on V_{CTL_A} to generate CLK_DLY. Circuit 360 can generate V_{CTL_B}, which has a value (e.g., voltage value) based on frequency CLK1_freq of CLK1. Delay line 350 can adjust the delay (e.g., loop delay) applied to CLK_DLY based on V_{CTL_B} to generate CLKDLL_{OUT}.

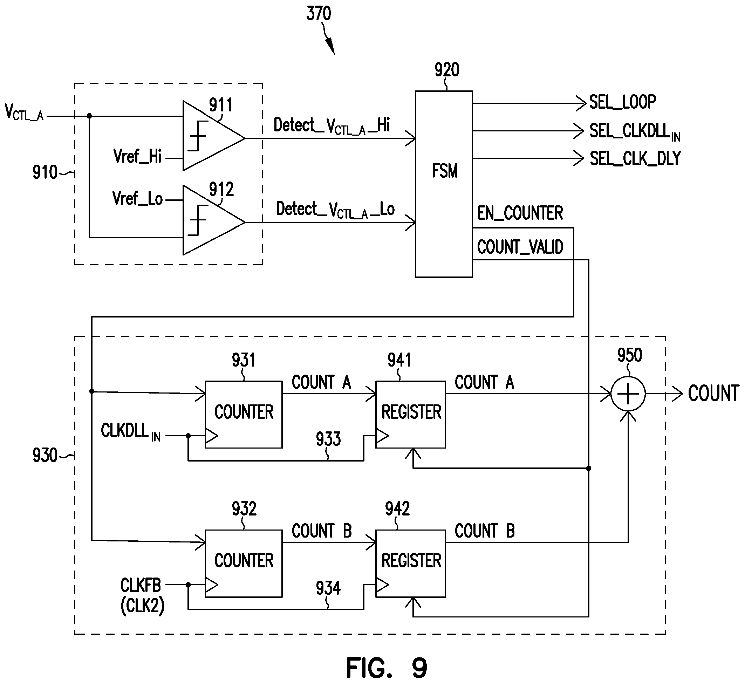

As shown in FIG. 3, device 320 can also include control circuitry 370 that can operate to control part of control part of the operation of DLL circuitry 322. Control circuitry 370 can cause DLL circuitry 322 to operate until CLKDLL_{IN} and CLKFB (CLK1 and CLK2) are synchronized. The components and operation of control circuitry 370 are described in more detail below with reference to FIG. 9 through FIG. 10C.

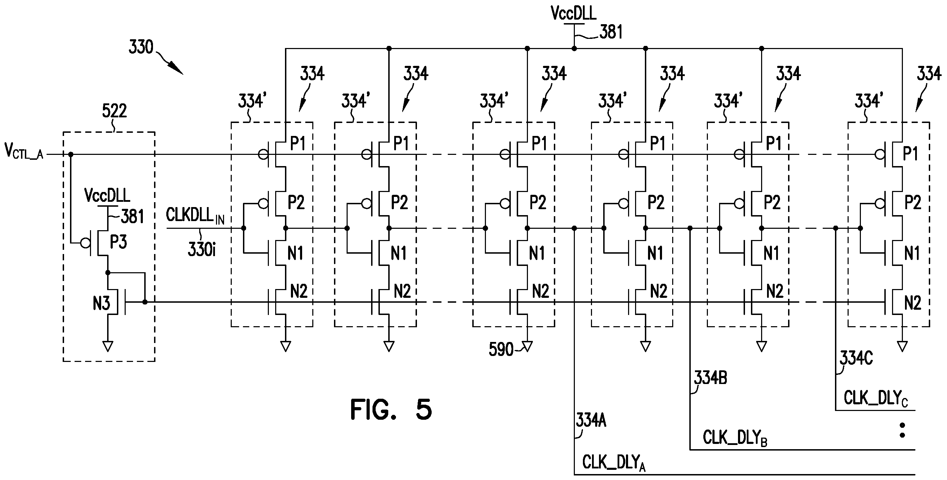

FIG. 5 shows part of the delay line 330 of FIG. 3, according to some embodiments described herein. As shown in FIG. 5, delay line 330 can include a bias circuit 522 coupled to delay stages 334. Each delay stage 334 of delay line 330 can be an inverter-based buffer stage that can include a delay element 334'. Delay line 330 can be a current-starved voltage-controlled delay line. The delay applied by each delay element 334' can be based on the value of V_{CTL_A}.

Each delay element 334' can include transistors P1, P2, N1, and N2 (forming an inverter) coupled between supply node 381 and a supply node (e.g., ground connection) 590. Bias circuit 522 can include transistors P3 and N3 coupled to delay stages 334 in ways shown in FIG. 5. Transistors N1, N2, N3, and N4 can include n-type transistors (e.g., n-channel metal-oxide-semiconductor (NMOS) transistors). Transistors P1, P2, and P3 can include p-type transistors (e.g., p-channel metal-oxide-semiconductor (PMOS) transistors).

The gates of transistors N1 and P2 of a respective delay element 334' of a respective delay stage 334 can be coupled to each other at the input node of the respective delay stage 334 to receive an input clock signal (e.g., CLKDLL_{IN}). The drain terminals of transistors N1 and P2 of a delay element 334' of a respective delay stage 334 can be coupled to each other at the output node (e.g., node 334A) of a respective delay stage 334 to provide an output clock signal (e.g., CLK_DLY_{A}). The gates of transistors P1 and P3 can be structured to receive control information V_{CTL_A}. Output nodes 334A, 334B, and 334C of respective delay stages 334 (that provide CLK _DLY_{A}, CLK _DLY_{B}, and CLK_DLY_{C}, respectively) can be coupled to respective drain terminals of transistors N1 and P2 of delay elements 334' of respective delay stages 334, as shown in FIG. 5.

FIG. 5 shows an example where each delay stage 334 includes a single delay element 334'. However, in an alternative structure of delay line 330, each delay stage 334 can include multiple (e.g., two) series-connected delay elements 334'.

In FIG. 5, bias circuit 522 and delay stages 334 can be configured (e.g., tuned) to achieve a relatively large delay range across process variations, temperatures, and supply voltages. Delay line 330 can provide a minimum delay (in time unit) when control information V_{CTL_A} has one value (e.g., lowest voltage value) and a maximum delay (in time unit) when control information V_{CTL_A} has another value (e.g., highest voltage value). The portion of delay stages 334 (that provide CLK _DLY_{A}, CLK _DLY_{B}, and CLK_DLY_{C}) can be configured based on a calibration algorithm (described below with reference to FIG. 9 through FIG. 10C).

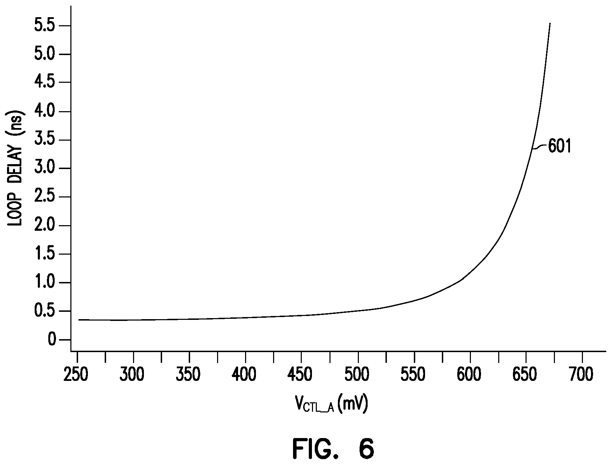

FIG. 6 is diagram showing an example relationship between delay and control information associated with delay line 330 of FIG. 3, according to some embodiments described herein. In FIG. 6, a loop delay (vertical axis, in nanosecond unit) corresponds to the delay (time delay) applied to CLKDLL_{IN} (FIG. 3) by delay line 330. V_{CTL_A} (x-axis, in millivolt unit) corresponds to the voltage value of V_{CTL_A}. As shown by curve 601 in FIG. 6, the delay exhibits a nonlinear relationship with V_{CTL_A} and is exponential after a certain threshold voltage.

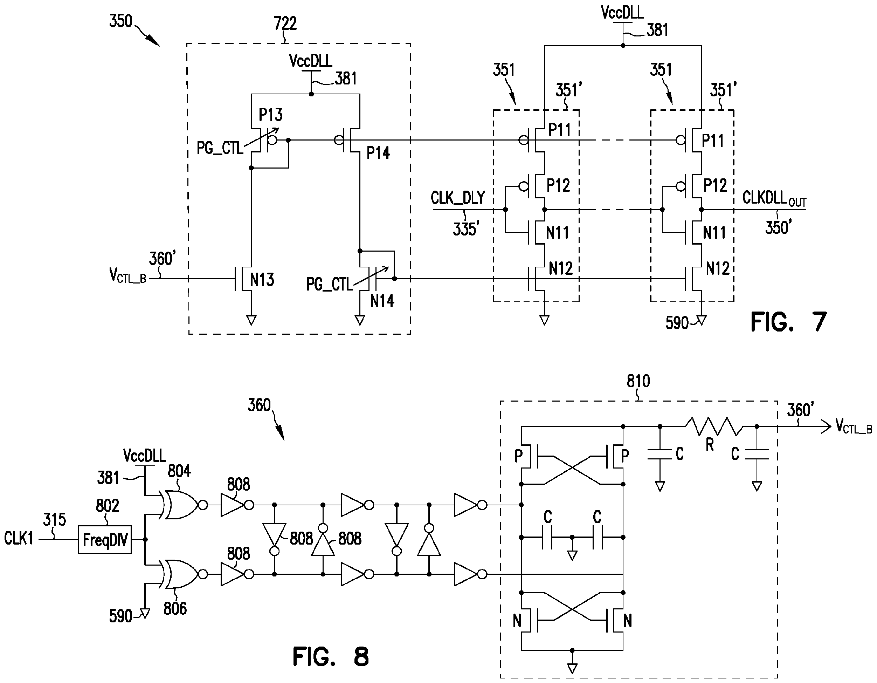

FIG. 7 shows part of delay line 350 of FIG. 3, according to some embodiments described herein. As shown in FIG. 7, delay line 350 can include a bias circuit 722 and delay elements 351' coupled to bias circuit 722. Each of delay stages 351 can include a delay element 351' (or alternatively multiple (e.g., two) delay elements 351'). Each delay stage 351 can be an inverter-based buffer stage. As shown in FIG. 7, each delay element 351' can include transistors P11, P12, N11, and N12 (forming an inverter) coupled between supply node 381 and supply node 590. Bias circuit 722 can include transistors P13, P14, N13, and N14 coupled to delay stages 351 in ways shown in FIG. 7. Transistors N11, N12, N13, and N14 can include n-type transistors (e.g., NMOS transistors). Transistors P11, P12, P13, and P14 can include p-type transistors (e.g., PMOS transistors).

The gates of transistors N1 and P2 of a respective delay stage 351 can be coupled to each other at the input node of the respective delay stage 351 to receive an input clock signal (e.g., CLK_DLY). The drain terminals of transistors N11 and P12 of a respective delay stage 351 can be coupled to each other at the output node of a respective delay stage 351 to provide an output clock signal (e.g., CLKDLL_{OUT}).

The gates of transistors N13 be structured to receive control information V_{CTL_B}. Delay line 350 can be a current-starved voltage-controlled delay line. The delay (time delay) applied by each delay stage 351 can be based on the value of V_{CTL_B}. V_{CTL_B} can have a lowest value and a highest value. The value of V_{CTL_B} can be based on (e.g., can be proportional to) frequency CLK1_freq of clock signal of CLK1. For example, the lowest and highest values of V_{CTL_B} can be associated with the lowest and highest values, respectively, of frequency CLK1_freq of clock signal CLK1.

The delay applied by delay line 350 to CLKDLL_{IN}_DLY (to provide CLKDLL_{OUT}) can be inversely proportional to the value (e.g., voltage value) of V_{CTL_B}. The value of V_{CTL_B} can be adjusted (e.g., increased or decreased) to adjusted (e.g., increase or decrease) the value of information PG_CNTL (which is used to adjust (e.g., increase or decrease) the amount of delay applied to CLKDLL_{IN}_DLY by delay line 350. For example, a higher value of V_{CTL_B} can cause delay line 350 to apply a smaller delay to CLKDLL_{IN}_DLY. A lower value of V_{CTL_B} can cause delay line 350 to apply a larger delay to CLKDLL_{IN}_DLY. In this example, delay line 350 can apply a minimum delay to CLKDLL_{IN}_DLY responsive to V_{CTL_B} having a highest value (e.g., associated with a higher frequency of CLK1). Delay line 350 can apply a maximum delay to CLKDLL_{IN}_DLY responsive to V_{CTL_B} having a lower value (e.g., associated with a lower frequency of CLK1).

FIG. 8 shows detail of circuit 360 of the DLL circuitry of FIG. 3, according to some embodiments described herein. As shown in FIG. 8, circuit 360 can include a frequency divider (FreqDIV) 802, logic gates 804, inverters 808 (not all inverters are labeled), a voltage generator (e.g., charge pump) 810 including transistors N and P, capacitors C, and a resistor R. Frequency divider 802 can operate to permit CLK1 frequency to remain high while presenting a scaled-down frequency to the inputs of inverters 808, thereby mitigating the negative effects of parasitic input capacitance of inverters 808. Logic gates 804, inverters 808, and voltage generator 810 can form a cross-couple inverter-based charge pump to provide V_{CTL_B} at output node 360' based on the frequency of CLK1 received at node 315. As described above, the value of V_{CTL_B} can be proportional to the value of the frequency of CLK1. For example, a lower value of V_{CTL_B} can be associated with lower frequency of CLK1. A higher value of V_{CTL_B} can be associated with higher frequency of CLK1.

FIG. 9 shows control circuitry 370 of FIG. 3, according to some embodiments described herein. As shown in FIG. 9, control circuitry 370 can include a circuit 910 (which includes comparators 911 and 912), a finite state machine (FSM) 920. Circuit 910 can include comparators (e.g., voltage comparators) 911 and 912). Circuit 930 can include counters (e.g., digital counters) 931 and 932, registers 941 and 942, and a calculation circuit 950.

Comparator 911 can include input nodes to receive V_{CTL_A} and a voltage Vref_Hi (e.g., threshold voltage of comparator 911), and an output node to provide information Detect_Vctla_Hi. The value (e.g., binary value of "1" or "0") of information Detect_Vctla_Hi can be based on the result of a comparison between the values (voltage values) of V_{CTL_A} and voltage Vref_Hi.

Comparator 912 can include input nodes to receive V_{CTL_A} and a voltage Vref_Lo (e.g., threshold voltage of comparator 912), and an output node to provide information Detect_Vctla_Lo. The value (e.g., binary value of "1" or "0") of information Detect_Vctla_Lo can be based on the result of a comparison between the values (voltage values) of V_{CTL_A} and voltage Vref_Lo.

For simplicity, voltages Vref_Lo and Vref_Hi are sometimes called Vref_Lo and Vref_Hi, respectively, (without the term "voltage" or "voltages").

The values of Vref_Lo and Vref_Hi can be determined (e.g., predetermined) using a look-up table (not shown) that can be prepopulated with values based on simulations of delay line 330. The values of Vref_Lo and Vref_Hi can be dependent on frequency of CLK1. The range of voltage Vref_Lo to Vref_Hi defines a valid range of V_{CTL_A} in which Vref_Lo and Vref_Hi can correspond to lower and higher limits, respectively, of the voltage range (that defines the valid range of V_{CTL_A}). In an example, higher frequencies (associated with CLK1) can be associated with the lower limit (e.g., voltage Vref_Lo) of the valid range of V_{CTL_A}. Lower frequencies (associated with CLK1) can be associated with the higher limit (e.g., voltage Vref_Hi) of the valid range of V_{CTL_A}.

As shown in FIG. 9, FSM 920 can receive information (e.g., input information) Detect_Vctla_Hi and Detect_Vctla_Lo. FSM 920 can provide information SEL LOOP, SEL_CLKDLL_{IN}, SEL_CLK_DLY (as also shown in FIG. 3), EN COUNTER, and COUNT VALID.

As shown in FIG. 9, counter 931 can include an input node (e.g., enable node coupled to node 933) to receive information EN_COUNTER, an input node (e.g., clock input node) to receive CLKDLL_{IN}, and an output node to provide information COUNTA. Counter 932 can include an input node (e.g., enable node) to receive information EN_COUNTER, an input node (e.g., enable node coupled to node 934) to receive CLKFB (which can be similar to CLK2), and an output node to provide information COUNTB.

As shown in FIG. 9, register 941 can include an input node to receive information COUNTA, an input node (e.g., clock input node) to receive CLKFB (which can be similar to CLK2), an input node to receive information COUNT_VALID, and an output node to provide information COUNTA to calculation circuit 950.

Register 942 can include an input node to receive information COUNTB, an input node (e.g., clock input node) to receive CLKFB (which can be similar to CLK2), an input node to receive information COUNT VALID, and an output node to provide information COUNTB to calculation circuit 950.

Calculation circuit 950 can include input nodes to receive information COUNTA and COUNTB, respectively, and an output node to provide m (loop delay information m). The value of m can be the difference (a subtraction result) between the values of information COUNTA and COUNTB.

The following description describes operation of device 320 including its components described above with respect to FIG. 3 through FIG. 9.

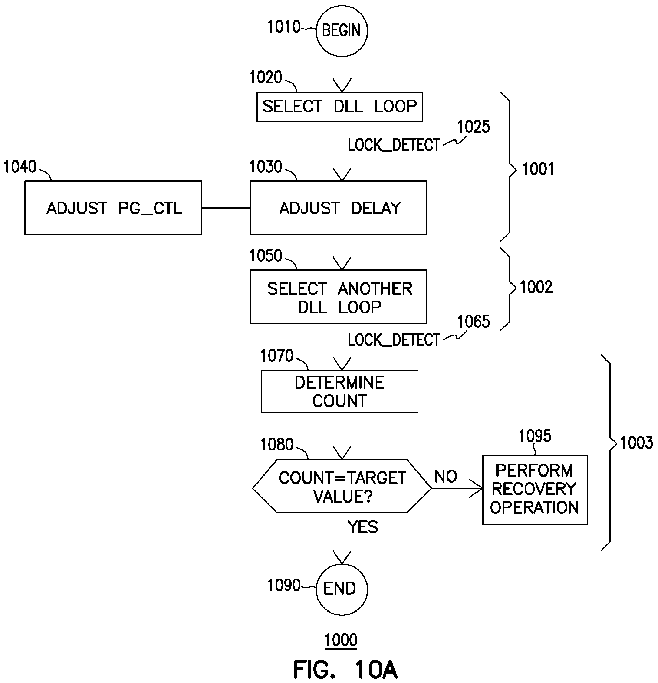

FIG. 10A is a flowchart showing a method 1000 of operating device 320 described above with respect to FIG. 3 through FIG. 9, including operating DLL circuitry 322 of device 320, according to some embodiments described herein. Method 1000 can be performed in part by control circuitry 370 (FIG. 3 and FIG. 9). DLL circuitry 322 (described above) can be implemented to accommodate a relatively wide range of frequencies and distribution voltages that can also support dynamic voltage and frequency scaling. In an implementation, DLL circuitry 322 can be configured to determine a lowest possible value of m (loop delay information) during an initial lock state. DLL circuitry 322 can stay locked to this value of m (in the initial lock state) where voltage and frequency of clock signals provided to the device may change during a normal operation. Further (as shown in FIG. 6), since the delay of delay line 330 exhibits a nonlinear relationship with V_{CTL_A} and is exponential after a certain threshold voltage, the value of V_{CTL_A} is kept within deterministic bounds to maintain proper operation of DLL circuitry 322. In an example, the value of V_{CTL_A} can be configured to be within a voltage range that can include lower limit (e.g., minimum value) such as voltage Vref_Lo (FIG. 9) and a higher limit (e.g., maximum value) such as voltage Vref_Hi (FIG. 9). To address these conditions, device 320 (FIG. 3) can run FSM 920 (as described below) during an initial startup as opposed to running per part HVM calibration. Running FSM 920 during each initial lock (to calibrate DLL circuitry 322 during each initial startup) can provide improvements such as lower cost and improved aging resistance.

As shown in FIG. 10A, method 1000 can include three phases (e.g., operational stages) 1001, 1002, and 1003. During phase 1001, method 1000 can cause DLL circuitry 322 to operate to achieve an initial lock state. During phase 1002, method 1000 can cause DLL circuitry 322 to operate to achieve a subsequent lock state (an additional lock state after the initial lock state). During phase 1003, method 1000 can determine whether a condition is met (e.g., whether m is equal to a target value) and perform appropriate operations based on the condition (e.g., based on whether m is equal to the target value). The following description refers to FIG. 10A and FIG. 3.

During phase 1001, method 1000 can begin at activity 1010. In activity 1010, MUX 332 (FIG. 3) can select CLK1 and provide it to input node 330i of delay line 330 (FIG. 3) of DLL circuitry 322 as CLKDLL_{IN}.

Then, method 1000 can continue with activity 1020 to select a DLL loop (e.g., tight loop) that can place (e.g., set) DLL circuitry 322 in an initial mode (e.g., tight loop mode). In FIG. 3, information SEL_LOOP can be provided with one value in the initial mode (in activity 1020) to allow MUX 352 to select CLKDLL_{OUT} to be CLKFB (FIG. 3). In a subsequent mode (e.g., long loop mode described below in activity 1050) information SEL_LOOP can be provided with another value to allow MUX 352 to select CLK2 (instead of CLKDLL_{OUT}) to be CLKFB.

In activity 1020 of FIG. 10A, method 1000 can cause DLL circuitry 322 to operate to achieve an initial lock state (in the tight loop mode) at CLKDLL_{IN} and CLKFB (based on CLKDLL_{OUT}) can be synchronized or deemed to be synchronized (e.g., as shown at time t1 of FIG. 2).

As shown in FIG. 10A, method 1000 can include detecting (in activity 1025) whether an initial lock state is achieved (e.g., whether CLKDLL_{IN} and CLKFB (based on CLKDLL_{OUT}) are synchronized). In FIG. 10A, "LOCK DETECT" indication detected by activity 1025 indicates that DLL circuitry 322 (FIG. 3) achieves an initial lock state (CLK1 and CLKDLL_{OUT} are synchronized).

Method 1000 can continue with activity 1030 responsive to the detection of an initial lock state in activity 1025. In an example, CLKDLL_{IN} and CLKFB (based on CLKDLL_{OUT}) can be synchronized in one cycle (one period) of CLK1. In this example, the delay (time delay) applied by delay line 330 (FIG. 3) to CLKDLL_{IN} (to achieve an initial lock state) can be equal to one cycle of CLK1.

In activity 1030 (after the detection of initial lock state) device 320 can operate to monitor the value (level) of V_{CTL_A}. Circuit 910 (FIG. 9) can be used such that comparators 911 and 912 can operate to compare the value of V_{CTL_A} with Vref_Hi and Vref_Lo (e.g., threshold voltages of comparators 911 and 912, respectively) as part of monitoring the value of V_{CTL_A}. Based on the value of V_{CTL_A}, activity 1030 (e.g., by using algorithm included FSM 920) can adjust (e.g., tune) the delay in DLL circuitry 322 to bring (or keep) V_{CTL_A} within the valid bounds (e.g., within the voltage range defined by voltages Vref_Lo and Vref_Hi). DLL circuitry 322 (FIG. 3) can be configured with two tuning features (e.g., tuning knobs) that include information SEL_CLK_DLY and information PG_CNTL. Information SEL_CLK_DLY can be provided to control input (control input node 335S in FIG. 3) of MUX 335 to adjust (e.g., increase or decrease) the number of delay stages 334 of delay line 330 (FIG. 3) that DLL circuitry 322 uses to generate CLK_DLY. Information PG_CNTL can be used by DLL circuitry 322 to modulate the delay strength of delay line 350 (FIG. 3). The value of information PG_CNTL can be controlled (e.g., adjusted) by controlling (adjusting) the value of V_{CTL_B} (FIG. 7).

In activity 1030, if the value of V_{CTL_A} is detected to be relatively high, such as when Detect_Vctla_Hi in FIG. 9 has a value corresponding to a binary 1 (e.g., when V_{CTL_A} > Vref_Hi), FSM 920 in FIG. 9 can provide information SEL_CLKDLL_{IN} having a value (e.g., a higher value) to increase the delay applied by delay line 330 (e.g., increase the number of delay stages 334 used to apply delay to CLKDLL_{IN}). Increasing the delay in activity 1030 can correspond to increasing the number of delay stages 334 used in delaying CLKDLL_{IN} (FIG. 3).

If the value of V_{CTL_A} is detected to be relatively low, such as when Detect_Vctla_Lo in FIG. 9 has a value corresponding to a binary 1 (e.g., when V_{CTL_A} < Vref_Lo), FSM 920 in FIG. 9 can provide information SEL_CLKDLL_{IN} having a value (e.g., a lower value) to decrease the delay applied by delay line 330 (e.g., decrease the number of delay stages 334 used to apply delay to CLKDLL_{IN}). Decreasing the delay in activity 1030 can correspond to decreasing the number of delay stages 334 used in delaying CLKDLL_{IN} (FIG. 3).

Method 1000 can include activity 1040 to adjust the value of PG_CNT modulate the delay strength of delay line 350 (FIG. 3) based on whether the delay applied to CLKDLL_{IN} (FIG. 3) by delay line 330 is at a minimum delay (e.g., CLK_DLY_{A} in FIG. 3) or is at a maximum delay (e.g., CLK_DLY_{C} in FIG. 3). For example, activity 1040 can increase the value of PG_CTRL (FIG. 3 and FIG. 7) if the delay applied to CLKDLL_{IN} (FIG. 3) by delay line 330 is at a minimum delay. In another example, activity 1040 can decrease the value of PG_CTRL (FIG. 3 and FIG. 7) if the delay applied to CLKDLL_{IN} (FIG. 3) by delay line 330 is at a maximum delay.

In phase 1002 of FIG. 10A, method 1000 can continue with activity 1050 to select another DLL loop (e.g., long loop) that can place (e.g., set) DLL to place DLL circuitry 322 in a subsequent mode (e.g., long loop mode). In the subsequent mode in activity 1050, information SEL_LOOP can be provided with another value to allow MUX 352 (FIG. 3) to select CLK2 (instead of CLKDLL_{OUT}) to be CLKFB. Activity 1050 can include disabling PFD 341 in FIG. 3, causing MUX 352 to select CLK2 to be CLKFB, and enabling PFD 341.

Method 1000 in FIG. 10A can include detecting (in activity 1065) whether a subsequent lock state in the long loop mode is achieved (e.g., whether CLKDLL_{IN} and CLKFB (based on CLK2) are synchronized). In FIG. 10A, "LOCK DETECT" indication detected by activity 1065 indicates that DLL circuitry 322 (FIG. 3) achieves a subsequent lock state (CLK1 and CLK2 are synchronized). In an example, in this mode (e.g., long loop mode), the delay through clock distribution circuitry 328 (FIG. 3) may be less than one clock period (or not greater than one clock period), such that DLL circuitry 322 can be locked to the selected (e.g., predetermined) value of m (e.g., m = 2). In this example, CLK1 and CLK2 can be synchronized in two clock cycles of CLK1 (e.g., synchronized at time t2 in FIG. 2).

However, a situation may occur where the clock frequency is relatively high and the DLL circuitry 322 locks to a higher harmonic of the clock period (e.g., m > 2). In another situation, clock distribution circuitry 328 can be relatively large, such that the smallest loop delay can be greater than two (smallest loop delay > 2). Phase 1003 of method 1000 can include activities to handle these situations.

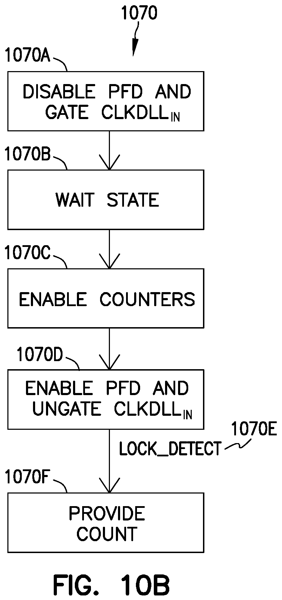

As shown in phase 1003 of FIG. 10A, method 1000 can include activity 1070 to determine the value of information COUNT. FIG. 10B shows detail of activity 1070 of FIG. 10A.

As shown in FIG. 10B, activity 1070 can include activity 1070A through activity 1070F. Activity 1070A can include disabling PFD 341 (FIG. 3) and gating (e.g., not toggling) CLKDLL_{IN} at node delay line 330i in FIG. 3 (and node 933 in FIG. 9). Activity 1070B can including activating a wait state to clear the clock pipeline in DLL circuitry 322. Activity 1070C can include enabling counters 931 and 932 (FIG. 9). Activity 1070D can include enabling PFD 341 (FIG. 3) and ungating (e.g., toggling) CLKDLL_{IN} at node 330i in FIG. 3 (and node 933 in FIG. 9). In FIG. 9, counters 931 and 932 (after being enabled in activity 1070C) can operate to count the cycles (periods) of CLKDLL_{IN} at and CLKFB, respectively, while DLL circuitry 322 (FIG. 3) operates to achieve a lock state (to synchronize clock signals CLKDLL_{IN} and CLKFB (based on CLK2) in FIG. 3). The count values COUNTA and COUNTB from counters 931 and 932, respectively, are provided to registers 941 and 942, respectively.

In FIG. 10B, activity 1070E can include detecting whether DLL circuitry 322 is in a lock state (e.g., whether clock signals CLKDLL_{IN} and CLKFB (based on CLK2) in FIG. 3 are synchronized). In FIG. 10B, "LOCK DETECT" indication detected by activity 1070E indicates that DLL circuitry 322 (FIG. 3) achieves the lock state.

Activity 1070F can include provide (e.g., generate) information COUNT. Providing information COUNT can include sampling counter values COUNTA and COUNTB (performed registers 941 and 942 of FIG. 9) in response information COUNT_VALID and then providing counter values COUNTA and COUNTB to calculation circuit 950 (FIG. 9). Calculation circuit 950 can operate to perform an operation (e.g., subtraction) to provide information COUNT having a value based on the calculation. The value of information COUNT can be the different in values between count values COUNTA and COUNTB. As further described below with reference to FIG. 10A, the value of information COUNT can be compared with a target value (which is a selected value of m) to determine whether DLL circuitry 322 achieves a lock state based on the value of m.

Referring to FIG. 10A, method 1000 can include activity 1080 to determine whether the value of information COUNT (from FIG. 10B) is equal to a target value (which is a selected value of m). If information COUNT is determined to be equal to a target value (indicated by "YES" in activity 1080 FIG. 10A, for example COUNT = 2 = m) then it can be determined that DLL circuitry 322 can be in a lock state at the target value (e.g., at m = 2) and method 1000 can end at activity 1090 (FIG. 10A). DLL circuitry 322 (FIG. 3) can remain in the lock state in activity 1090.

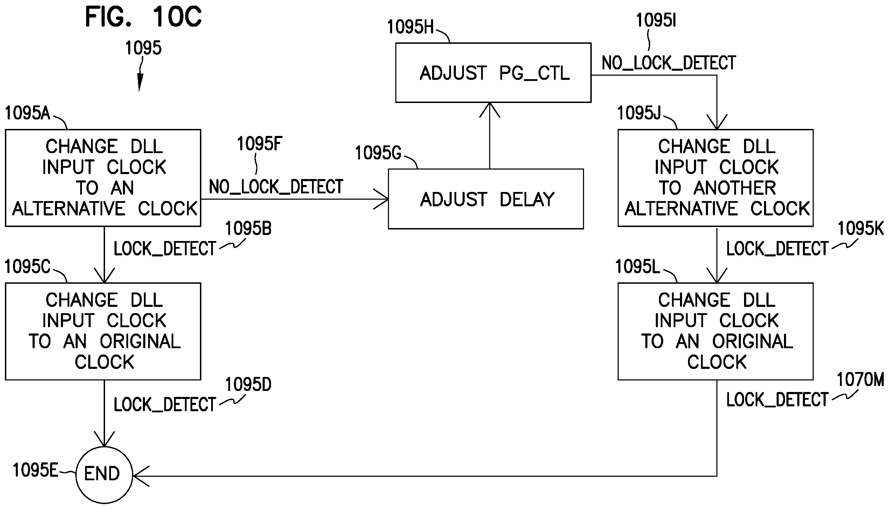

In FIG. 10A, if information COUNT is determined to be not equal to a target value (indicated by "NO" in activity 1080 FIG. 10A), for example COUNT > 2, then it can be determined that DLL circuitry 322 may not be in a lock state at the target value (e.g., at m = 2). In this case, method 1000 can perform (e.g., using FSM 920 of FIG. 9) a recovery operation in activity 1095 (shown in detail in FIG. 10C).

As shown in FIG. 10C, activity 1095 can include activities 1095A through activity 1095L. Activity 1095 can be performed to handle two situations that might occur when DLL circuitry 322 is in a lock state (detected in activity 1070E in FIG. 10B) and the value of information COUNT (FIG. 9 and activity 1080 in FIG. 10A) is not equal to a target value (e.g., not equal to m = 2). In one situation, the frequency of DLL input clock signal (e.g., frequency of CLKDFLL_{IN} which is based on CLK1) may be too high and DLL circuitry 322 has locked to a loop delay that is greater than 2 (e.g., COUNT > 2). In this situation, activity 1095A can include changing the input clock signal provided to DLL circuitry 322 from CLK1 to an alternative clock signal, which can be CLKDIV in FIG. 3. As described above, frequency divider 331 (FIG. 3) can generate CLKDIV, such that the frequency CLK1_freq of CLK1 can be a multiple of the frequency CLKDIV freq of CLKDIV (e.g., CLK1 freq = m*CLKDIV_freq).

In FIG. 10C, activity 1095A can include disabling PFD 341 (FIG. 3), selecting CLKDIV (CLK1 divided by m = 2) to be CLKDLL_{IN}, and enabling PFD 341. Using the divider 331 to generate CLKDIV and providing it as CLKDLL_{IN} to the input node (coupled to node delay line 330i) of the DLL circuitry 322 in this fashion ensures that the DLL circuitry 322 locks to m = 2. In FIG. 10C, activity 1095B can include detecting whether DLL circuitry 322 is in a lock state (e.g., whether clock signals CLKDLL_{IN} (based on CLKDIV) and CLKFB (based on CLK2) in FIG. 3 are synchronized. In FIG. 10C, "LOCK DETECT" indication detected by activity 1095B indicates that DLL circuitry 322 (FIG. 3) achieves a lock state.

Activity 1095C (responsive to the detection of the lock state in activity 1095B) can include changing the DLL input clock signal from CLKDIV back to the original (initial) clock signal (e.g., undivided clock signal CLK1). Changing the DLL input clock signal from CLKDIV back to the original clock signal (e.g., CLK1) allows DLL circuitry 322 to operate with the full speed (the original undivided clock signal (e.g., CLK1)) through clock distribution circuitry 328 (FIG. 3). Activity 1095C can include disabling PFD 341 (FIG. 3), selecting CLK1 (undivided clock signal) to be CLKDLL_{IN}, performing a wait state (e.g., for two clock cycles), and enabling PFD 341. DLL circuitry 322 can operate until a lock state (indicated by "LOCK DETECT") is detected in activity 1095D. Activity 1095E can allow DLL circuitry 322 to operate and remain in the lock state at m = 2.

The following description discuss another situation where the value of information COUNT (FIG. 9 and activity 1080 in FIG. 10A) is not equal to a target value (e.g., not equal to m = 2). In this situation, the clock distribution (e.g., represented by clock distribution circuitry 328 in FIG. 3) may be relatively large such that the sum of the minimum delay through delay line 330, delay line 350, and distribution circuitry 328 in FIG. 3 may still be greater than two clock cycles. In this situation, instead of a detection of a lock state (in activity 1095B), such a lock state may not be detected (as shown in activity 1095F) after a time interval (e.g., a predetermined timer interval) has lapsed. Activity 1095G and activity 1095H can include adjusting the delay and PG_CNT, respectively, to continue allow DLL circuitry 322 to achieve a lock state. Activity 1095G and activity 1095H can be similar to activity 1030 and 1040, respectively, of FIG. 10A. For example, activity 1095G can include increasing the delay applied by delay line 330 (FIG. 3) if value of V_{CTL_A} is detected to be relatively high, such as when Detect_Vctla_Hi in FIG. 9 has a value corresponding to a binary 1. Activity 1095G can include decreasing the delay applied by delay line 330 (FIG. 3) if value of V_{CTL_A} is detected to be relatively low, such as when Detect_Vctla_Lo in FIG. 9 has a value corresponding to a binary 1. Activity 1095H can include increasing the value of PG_CTRL (FIG. 3 and FIG. 7) if the delay applied to CLKDLL_{IN} (FIG. 3) by delay line 330 is at a minimum delay.

As shown in activity 1095I in FIG. 10C, a lock state may not be detected and PG_CNT may be at its maximum value. This situation can occur when the clock distribution (e.g., clock distribution circuitry 328) is relatively large such that the sum of the minimum delay through delay lines 330 and 350 and the clock distribution is still greater than two clock cycles, as mentioned above. DLL circuitry 322 (FIG. 3) may remain unlocked and V_{CTL_A} may continue to be below the lower threshold voltage despite delay line 330 is at its minimum delay and PG_CNT being at its maximum value. In this situation, device 320 determines that the lowest possible value of loop delay is three (which is greater than a target value of m = 2). Based on this determination, device 320 can change the divider value (of frequency divider 331) from 2 to 3 (from dividing CLK1 by 2 to dividing CLK1 by 3).

As shown in FIG. 10C, activity 1095J can include changing the input clock signal to DLL circuitry 322 from to another alternative clock signal. For example, activity 1095J can include changing the input clock signal to DLL circuitry 322 from the alternative CLKDIV (based on CLK1 divided by 2 in activity 1095A) to another alternative CLKDIV (e.g., based on CLK1 divided by 3 in activity 1095J). Activity 1095J can include disabling PFD 341 (FIG. 3), selecting CLKDIV (CLK1 divided by 3) to be CLKDLL_{IN}, and enabling PFD 341. Activity 1095K in FIG. 10C can include detecting whether DLL circuitry 322 is in a lock state (e.g., whether clock signals CLKDLL_{IN} (based on CLK1 divided by 3) and CLKFB (based on CLK2) in FIG. 3 are synchronized). In FIG. 10C, the "LOCK DETECT" indication detected by activity 1095K indicates that DLL circuitry 322 (FIG. 3) achieves a lock state.

Activity 1095L (responsive to the detection of the lock state in activity 1095K) can include changing the DLL input clock signal from CLKDIV (based on CLK1 divided by 3) back to the original clock signal (e.g., undivided clock signal CLK1). This allows DLL circuitry 322 to operate with the full speed (the original undivided clock signal (e.g., CLK1)) through clock distribution circuitry 328 (FIG. 3). Activity 1095L can include disabling PFD 341 (FIG. 3), selecting CLK1 (undivided clock signal) to be CLKDLL_{IN}, performing a wait state (e.g., for three clock cycles), and enabling PFD 341. DLL circuitry 322 can operate until a lock state (indicated by "LOCK DETECT") is detected in activity 1095M and continue with activity 1095E. In this situation, DLL circuitry 322 can continue to operate and remain in the lock state a m = 3, which is different from a target value (e.g., m = 2).

The device 320 including DLL circuitry 322 (which includes multiple delay lines 330 and 350) and operations, as described above, enable die-to-die common clock crossings using deskew DLL while supporting large FGV events without halting the system with a known latency of m clock cycles in the DLL loop. Device 320 including DLL circuitry 322 and operations, as described above, also allow lower power, lower latency, or both that may enable one cycle across the die-to-die interface. Including DLL circuitry 322 and control circuitry 370 in device 320 also avoids HVM calibration, thereby lowering test time and die cost.

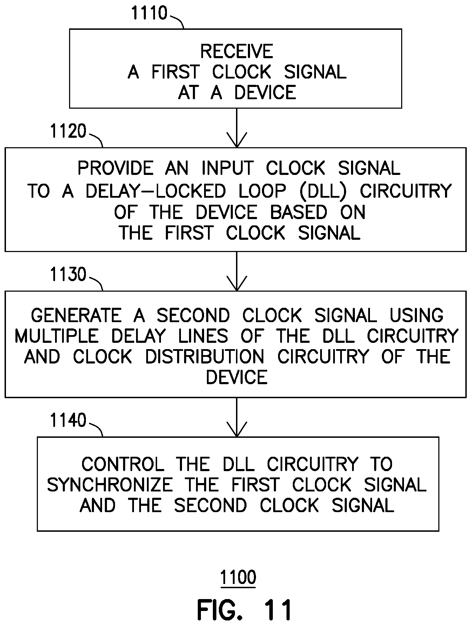

FIG. 11 shows a method 1100 of operating an apparatus, according to some embodiments described herein. Method 1100 can be performed by device 110, device 120, and device 320 described above with reference to FIG. 1 through FIG. 10C. Alternatively, method 1100 may be performed by two of a processor 1215, a memory device 1220, a memory controller 1230, a graphics controller 1240, and an I/O controller 1250 of a system 1200 (described below). In an example, method 1100 can be performed by hardware, software, firmware, or any combination of hardware, software, and firmware of an apparatus (e.g., apparatus 100 or system 1200) or devices described herein (e.g., device 110, device 120, and device 320, or processor 1215, memory device 1220, memory controller 1230, graphics controller 1240, and I/O controller 1250 of system 1200).

As shown in FIG. 11, method 1100 can include activities (e.g., operations) 1110, 1120, 1130, and 1140.

Activity 1110 can include receiving a first clock signal (e.g., CLK1) at a device (e.g., device 120 or device 320). Activity 1120 can include providing an input clock signal (e.g., CLKDLL_{IN}) to DLL circuitry of the device based on the first clock signal. Activity 1130 can include generating a second clock signal (CLK2) using multiple delay lines (e.g.., delay line 330 and 350) of the DLL circuitry and a clock distribution circuitry of the device. Activity 1140 can include controlling the DLL circuitry to synchronize the first and second clock signals.

Method 1100 described above can include fewer or more activities relative to activities 1110, 1120, 1130, and 1140 shown in FIG. 11. Method 1100 can include additional activities including activities and operations of the apparatuses (e.g., apparatus 100 and system 1200) and devices (e.g., devices 110, 120, and 320) described herein.

For example, generating the second clock signal in activity 1130 of FIG. 11 can include selecting a selected clock signal from multiple output nodes of first delay stages of a first delay line of multiple delay lines, providing the selected clock signal to a second delay line of the multiple delay lines to generate an output clock signal based on the selected clock signal, and providing the output clock signal to the clock distribution circuitry to generate the second clock signal based on the output clock signal.

In another example, controlling the DLL circuitry to synchronize the first and second clock signals in activity 1140 can include comparing the input clock signal and a feedback clock signal in a first mode of the DLL circuitry, wherein the feedback clock signal is based on the output clock signal, and comparing the input clock signal and a feedback clock signal in a second mode of the DLL circuitry, wherein the feedback clock signal is based on the output clock signal.

In another example, controlling the DLL circuitry to synchronize the first and second clock signals in activity 1140 can include dividing a frequency of the first clock signal to generate an alternative clock signal responsive the DLL circuitry achieving a lock state exceeding a target value of loop delay information. Activity 1140 can include synchronizing, using the DLL circuitry, the feedback clock signal and the input clock signal in which the input clock signal is based on the alternative clock signal. Activity 1140 can include, after the feedback clock signal and the input clock signal are synchronized (in which the input clock signal is based on the alternative clock signal), providing the first clock signal to the DLL circuitry as the input clock signal, and synchronizing the input clock signal and the feedback clock signal.

In another example, method 1100 can include sending the first clock signal from an additional device (e.g., device 110) to the device (e.g., device 120 or device 320).

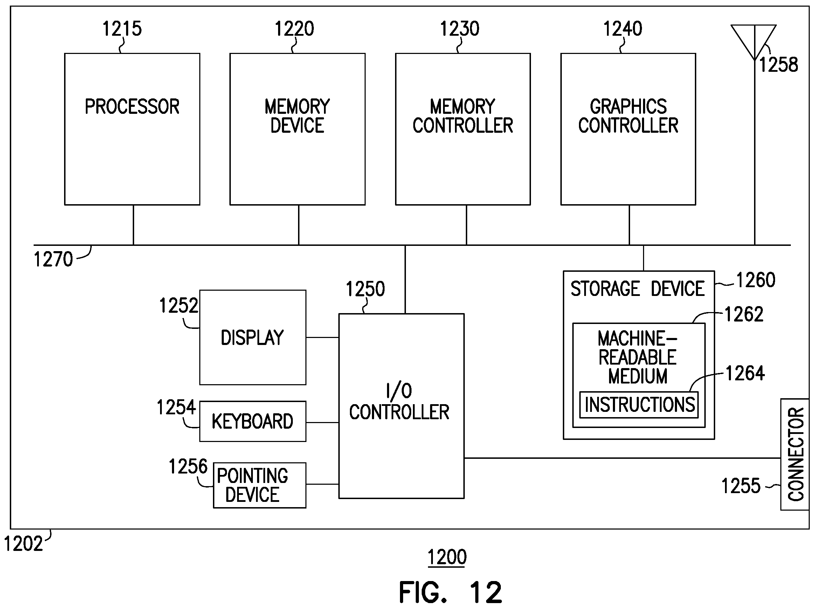

FIG. 12 shows an apparatus in the form of a system (e.g., electronic system) 1200, according to some embodiments described herein. System 1200 can be viewed as a machine. System (e.g., machine) 1200 can include or be included in a computer, a cellular phone, or other electronic systems. As shown in FIG. 12, system 1200 can include components (e.g., devices) located on a circuit board (e.g., PCB) 1202. The components can include processor (e.g., a hardware processor) 1215, memory device 1200, memory controller 1230, graphics controller 1240, I/O controller 1250, a display 1252, a keyboard 1254, a pointing device 1256, at least one antenna 1258, a storage device 1260, and a bus 1270. Bus 1270 can include conductive lines (e.g., metal-based traces on a circuit board 1202 where the components of system 1200 are located).

System 1200 may be configured to perform one or more of the methods and/or operations described herein. At least one of the components of system 1200 (e.g., at least one of processor 1215, memory device 1200, memory controller 1230, graphics controller 1240, and I/O controller 1250) can include a device (e.g., device 110, device 120, or device 320) described herein in which the device can include circuitry and operation, as described above with reference to FIG. 1 through FIG. 11.

In FIG. 12, processor 1215 can include a general-purpose processor or an application specific integrated circuit (ASIC). Processor 1215 can include a central processing unit (CPU) and processing circuitry. Graphics controller 1240 can include a graphics processing unit (GPU) and processing circuitry. Memory device 1200 can include a dynamic random-access memory (DRAM) device, a static random-access memory (SRAM) device, a flash memory device, phase change memory, or a combination of these memory devices, or other types of memory. FIG. 12 shows an example where memory device 1200 is a stand-alone memory device separated from processor 1215. In an alternative structure, memory device 1200 and processor 1215 can be located on the same IC chip (e.g., a semiconductor die or IC die). In such an alternative structure, memory device 1200 is an embedded memory in processor 1215, such as embedded DRAM (eDRAM), embedded SRAM (eSRAM), embedded flash memory, or another type of embedded memory.

Storage device 1260 can include drive unit (e.g., hard disk drive (HHD), solid-state drive (SSD), or another mass storage device). Storage device 1260 can include a machine-readable medium 1262 and processing circuitry. Machine-readable medium 1262 can store one or more sets of data structures or instructions 1264 (e.g., software) embodying or used by any one or more of the techniques or functions described herein. Instructions 1264 may also reside, completely or at least partially, within memory device 1200, memory controller 1230, processor 1215, or graphics controller 1240 during execution thereof by system (e.g., machine) 1200.

In an example, one of (or any combination of) processor 1215, memory 1220, memory controller 1230, graphics controller 1240, and storage device 1260 may constitute machine-readable media. Non-limiting machine-readable medium examples may include solid-state memories and optical and magnetic media. Specific examples of machine-readable media may include nonvolatile memory, such as semiconductor memory devices (e.g., EPROM or EEPROM) and flash memory devices; magnetic disks, such as internal hard disks and removable disks; magneto-optical disks; RAM; and CD-ROM and DVD-ROM disks.

FIG. 12 shows machine-readable medium 1262 as a single medium as an example. However, the term "machine-readable medium" may include a single medium or multiple media (e.g., a centralized or distributed database, and/or associated caches and servers) configured to store instructions 1264. Further, the term "machine-readable medium" may include any medium that is capable of storing, encoding, or carrying instructions for execution by system 1200 and that causes system 1200 to perform any one or more of the techniques of the present disclosure, or that is capable of storing, encoding or carrying data structures used by or associated with such instructions. In some examples, machine-readable media may include non-transitory machine-readable media. In some examples, machine-readable media may include machine-readable media that is not a transitory propagating signal.

Display 1252 can include a liquid crystal display (LCD), a touchscreen (e.g., capacitive or resistive touchscreen), or another type of display. Pointing device 1256 can include a mouse, a stylus, or another type of pointing device. In some structures, system 1200 does not have to include a display. Thus, in such structures, display 1252 can be omitted from system 1200.

Antenna 1258 can include one or more directional or omnidirectional antennas, including, for example, dipole antennas, monopole antennas, patch antennas, loop antennas, microstrip antennas, or other types of antennas suitable for transmission of radio frequency (RF) signals. In some structures, system 1200 does not have to include an antenna. Thus, in such structures, antenna 1258 can be omitted from system 1200.

I/O controller 1250 can include a communication module for wired or wireless communication (e.g., communication through one or more antennas 1258). Such wireless communication may include communication in accordance with WiFi communication technique, Long Term Evolution Advanced (LTE-A) communication technique, or other communication techniques.

I/O controller 1250 can also include a module to allow system 1200 to communicate with other devices or systems in accordance with to one or more of the following standards or specifications (e.g., I/O standards or specifications), including Universal Serial Bus (USB), DisplayPort (DP), High-Definition Multimedia Interface (HDMI), Thunderbolt, Peripheral Component Interconnect Express (PCIe), Ethernet, and other specifications.

Connector 1255 can include terminals (e.g., pins) to allow system 1200 to receive a connection (e.g., an electrical connection) from an external device (or system). This may allow system 1200 to communicate (e.g., exchange information) with such a device (or system) through connector 1255. Connector 1255 and at least a portion of bus 1270 can include conductive lines that conform with at least one of USB, DP, HDMI, Thunderbolt, PCIe, Ethernet, and other specifications.

FIG. 12 shows the components (e.g., devices) of system 1200 arranged separately from each other as an example. For example, each of processor 1215, memory device 1200, memory controller 1230, graphics controller 1240, and I/O controller 1250 can be included in (e.g., formed in or formed on) a separate IC chip (e.g., separate semiconductor die or separate IC die). In some structures of system 1200, two or more components (e.g., processor 1215, memory device 1200, graphics controller 1240, and I/O controller 1250) of system 1200 can be included in (e.g., formed in or formed on) the same IC chip (e.g., same semiconductor die), forming a SoC. Alternatively, two or more components (e.g., processor 1215, memory device 1200, graphics controller 1240, and I/O controller 1250) of system 1200 can be included in the same package (e.g., same SiP).

The illustrations of the apparatuses (e.g., apparatus 100, device 320, and system 1200) and methods (e.g., methods 1000 and 1100) described above are intended to provide a general understanding of the structure of different embodiments and are not intended to provide a complete description of all the elements and features of an apparatus that might make use of the structures described herein.

Any of the components described above with reference to FIG. 1 through FIG. 12 can be implemented in a number of ways, including simulation via software. Thus, apparatuses (e.g., apparatus 100, device 320, and system 1200) may all be characterized as "modules" (or "module") herein. Such modules may include hardware circuitry, single- and/or multi-processor circuits, memory circuits, software program modules and objects and/or firmware, and combinations thereof, as desired and/or as appropriate for particular implementations of various embodiments. For example, such modules may be included in a system operation simulation package, such as a software electrical signal simulation package, a power usage and ranges simulation package, a capacitance-inductance simulation package, a power/heat dissipation simulation package, a signal transmission-reception simulation package, and/or a combination of software and hardware used to operate or simulate the operation of various potential embodiments.

The apparatuses and methods described above can include or be included in high-speed computers, communication and signal processing circuitry, single- or multi-processor modules, single or multiple embedded processors, multicore processors, message information switches, and application-specific modules including multilayer, multichip modules. Such apparatuses may further be included as subcomponents within a variety of other apparatuses (e.g., electronic systems), such as televisions, cellular telephones, personal computers (e.g., laptop computers, desktop computers, handheld computers, tablet computers, etc.), workstations, radios, video players, audio players (e.g., MP3 (Motion Picture Experts Group, Audio Layer 3) players), vehicles, medical devices (e.g., heart monitor, blood pressure monitor, etc.), set top boxes, and others.

In the detailed description and the claims, the terms "first," "second," and "third," etc. are used merely as labels, and are not intended to impose numerical requirements on their objects.

In the detailed description and the claims, the term "on" used with respect to two or more elements (e.g., materials), one "on" the other, means at least some contact between the elements (e.g., between the materials). The term "over" means the elements (e.g., materials) are in close proximity, but possibly with one or more additional intervening elements (e.g., materials) such that contact is possible but not required. Neither "on" nor "over" implies any directionality as used herein unless stated as such.

In the detailed description and the claims, the term "adjacent" generally refers to a position of a thing being next to (e.g., either immediately next to or close to with one or more things between them) or adjoining another thing (e.g., abutting it or contacting it (e.g., directly coupled to) it).

In the detailed description and the claims, a list of items joined by the term "at least one of' can mean any combination of the listed items. For example, if items A and B are listed, then the phrase "at least one of A and B" means A only; B only; or A and B. In another example, if items A, B, and C are listed, then the phrase "at least one of A, B and C" means A only; B only; C only; A and B (excluding C); A and C (excluding B); B and C (excluding A); or all of A, B, and C. Item A can include a single element or multiple elements. Item B can include a single element or multiple elements. Item C can include a single element or multiple elements.

In the detailed description and the claims, a list of items joined by the term "one of" can mean only one of the list items. For example, if items A and B are listed, then the phrase "one of A and B" means A only (excluding B), or B only (excluding A). In another example, if items A, B, and C are listed, then the phrase "one of A, B and C" means A only; B only; or C only. Item A can include a single element or multiple elements. Item B can include a single element or multiple elements. Item C can include a single element or multiple elements.

Described implementations of the subject matter can include one or more features, alone or in combination as illustrated below by way of examples.

Example 1 is an apparatus comprising a first delay line of a delay-locked loop (DLL) circuitry including an input node to receive an input clock signal and delay stages coupled in series with the input node, a multiplexer including input nodes coupled to output nodes of a portion of the delay stages, and a second delay line of the DLL circuitry including an input node coupled to an output node of the multiplexer, and delay stages coupled in series with the input node of the second delay line, the second delay line including an output node to provide an output clock signal.

In Example 2, the subject matter of Example 1 includes subject matter wherein the DLL circuitry includes an additional multiplexer, the additional multiplexer including a first input node coupled to a clock node, a second input node coupled to a frequency divider, and an output node coupled to the input node of the first delay line.

In Example 3, the subject matter of Example 2 includes subject matter wherein the additional multiplexer is a first additional multiplexer, and the DLL circuitry includes a circuit, the circuit including a phase frequency detector, the phase frequency detector including a first input node coupled to the input node of the first delay line, a second input node coupled to an output node of the second delay line through a second additional multiplexer, and an output node coupled to a control input node of the first delay line.

In Example 4, the subject matter of any of Examples 2-3 includes subject matter wherein the DLL circuitry includes an additional circuit, the additional circuit including an input node coupled to the clock node, and an output node coupled to a control input node of the second delay line.

In Example 5, the subject matter of any Examples 2-4 includes clock distribution circuitry, including an input node coupled to the output node of the second delay line, and an output node coupled to an input node of the second additional multiplexer.

In Example 6, the subject matter of any of Examples 1-5 includes subject matter wherein a delay stage of the delay stages of the first delay line includes first transistors of a first transistor type, and second transistors of a second transistor type coupled to the first transistors, and wherein the DLL circuitry includes a bias circuit coupled to a gate of a transistor of the first transistors and a gate of a transistor of the second transistors.

In Example 7, the subject matter of Example 6 includes subject matter wherein a delay stage of the delay stages of the second delay line includes first additional transistors of the first transistor type, and second additional transistors of the second transistor type coupled to the first additional transistors, and wherein the DLL circuitry includes an additional bias circuit coupled to a gate of a transistor of the first additional transistors and a gate of a transistor of the second additional transistors.

In Example 8, the subject matter of any of Examples 1-7 includes subject matter wherein the apparatus comprises a system on chip (SoC), the SoC including an integrated circuit (IC) die, and wherein the DLL circuitry is included in the IC die.

In Example 9, the subject matter of any of Examples 1-7 includes a connector and an integrated circuit (IC) die coupled to the connector, the IC die including the DLL circuitry, wherein the connector conforms with at least one of Universal Serial Bus (USB), High-Definition Multimedia Interface (HDMI), Thunderbolt, Peripheral Component Interconnect Express (PCIe), and Ethernet specifications.

In Example 10, the subject matter of Example 6 includes subject matter wherein the transistor of the first transistors includes a p-type transistor, and the transistor of the second transistors includes an n-type transistor.

In Example 11, the subject matter of Example 7 includes subject matter wherein the transistor of the first additional transistors includes a p-type transistor, and the transistor of the second additional transistors includes an n-type transistor.

In Example 12, the subject matter of any of Examples 1-11 includes subject matter wherein the apparatus comprises a first die and a second die coupled to the first die, and wherein the DLL circuitry is included in the second die.

In Example 13, the subject matter of Example 12 includes subject matter wherein the apparatus comprises a conductive connection coupled between the first die and the second die, wherein the conductive connection is part of metal traces on a circuit board included in the apparatus.

Example 14 is an apparatus comprising a first delay line including an input node to receive an input clock signal based on a first clock signal at a clock input node, a first circuit to provide first control information to the first delay line based on a relationship between the input clock signal and a feedback clock signal, a first multiplexer including input nodes coupled to output nodes of a portion of delay stages of the first delay line, a second delay line including an input node coupled to an output node of the first multiplexer, a second circuit to provide second control information to the second delay line based on a frequency of the first clock signal, clock distribution circuitry including an input node coupled to an output node of the second delay line, and an output node to provide a second clock signal, and a second multiplexer including a first input node coupled to the output node of the second delay line, a second output node coupled to the output node of the clock distribution circuit, and an output node to provide the feedback clock signal.

In Example 15, the subject matter of Example 14 includes a third multiplexer, the third multiplexer including a first input node coupled to the clock input node, a second input node coupled to an output node of a frequency divider, the frequency divider including an input node coupled to the clock input node, and an output node coupled to the input node of the first delay line.

In Example 16, the subject matter of any of Examples 14-15 includes subject matter wherein the first circuit includes a phase frequency detector, a charge pump coupled to the phase frequency detector, and a filter coupled to the charge pump.

In Example 17, the subject matter of any of Examples 14-16 includes subject matter wherein the second circuit includes a charge pump coupled to the second delay line.

In Example 18, the subject matter of any of Examples 14-17 includes subject matter wherein the first multiplexer includes a control node to receive select information having a value based on a value of the first control information.

In Example 19, the subject matter of any of Examples 14-18 includes subject matter wherein the first control information includes a voltage signal, wherein a delay applied to the input clock signal by the first delay line is proportional to a voltage value of the voltage signal.

In Example 20, the subject matter of any of Examples 14-19 includes subject matter wherein the second control information includes a voltage signal, the voltage signal having a value proportional to the frequency of the first clock signal.

In Example 21, the subject matter of any of Examples 14-20 includes subject matter wherein the apparatus comprises a system in a package (SiP), the SiP including a first integrated circuit (IC) die including a clock output node coupled to the clock input node, and a second IC die, wherein the clock input node, the first delay line, the first circuit, the first multiplexer, the second delay line, the second circuit, the clock distribution circuitry, and the second multiplexer are included in the second IC die.

In Example 22, the subject matter of any of Examples 14-21 includes subject matter wherein the first delay line includes a first portion of the delay stages, a second portion of delay stages, and a third portion of delay stages, the second portion of delay stages are coupled between the first portion of the delay stages and the third portion of the delay stages, and wherein the portion of the delay stages coupled to the first multiplexer is the second portion of delay stages.

In Example 23, the subject matter of any of Examples 14-22 includes control circuitry, the control circuitry including comparators to monitor a value of the first control information to adjust a value select information at control input of the multiplexer.

In Example 24, the subject matter of any of Examples 14-23 includes counters to provide count of cycles of the input clock signal during synchronization of the input clock signal and the feedback signal.

Example 25 is method comprising receiving a first clock signal at a device, providing an input clock signal, based on the first clock signal, to a first delay-locked loop (DLL) circuitry, generating a second clock signal using multiple delay lines of the DLL circuitry and clock distribution circuitry of the device, and controlling the DLL circuitry to synchronize the first clock signal and the second clock signal.

In Example 26, the subject matter of Example 18 includes subject matter wherein generating the second clock signal includes selecting a selected clock signal from multiple output nodes of first delay stages of a first delay line of multiple delay lines, providing the selected clock signal to a second delay line of the multiple delay lines to generate an output clock signal based on the selected clock signal, and providing the output clock signal to the clock distribution circuitry to generate the second clock signal based on the output clock signal.

In Example 27, the subject matter of Example 25 includes subject matter wherein controlling the DLL circuitry includes comparing the input clock signal and a feedback clock signal in a first mode of the DLL circuitry, wherein the feedback clock signal is based on the output clock signal, and comparing the input clock signal and the feedback clock signal in a second mode of the DLL circuitry, wherein the feedback clock signal is based on the output clock signal.

In Example 28, the subject matter of Example 25 includes subject matter wherein controlling the DLL circuitry includes diving a frequency of the first clock signal to generate an alternative clock signal responsive the DLL circuitry achieving a lock state exceeding a target value of loop delay information, synchronizing, using the DLL circuitry, the feedback clock signal and the input clock signal in which the input clock signal is based on the alternative clock signal, after the feedback clock signal and the input clock signal, in which the input clock signal is based on the alternative clock signal, are synchronized, providing the first clock signal to the DLL circuitry as the input clock signal, and synchronizing the input clock signal and the feedback clock signal.

In Example 29, the subject matter of any of Examples 25-28 includes sending the first clock signal from an additional device to the device.

In Example 30, the subject matter of any of Examples 25-29 includes subject matter wherein the first device is included in a first chiplet and the second device is included in a second chiplet.

Example 31 at least one machine-readable medium including instructions that, when executed by processing circuitry, cause the processing circuitry to perform operations to implement any of Examples 1-30.

Example 32 is an apparatus comprising means to implement any of Examples 1-30.

Example 33 is a system to implement any of Examples 1-30.

Example 34 is a method to implement any of Examples 1-30.

The subject matter of Examples 1-34 may be combined in any combination.

The above description and the drawings illustrate some embodiments of the inventive subject matter to enable those skilled in the art to practice the embodiments of the inventive subject matter. Other embodiments may incorporate structural, logical, electrical, process, and other changes. Examples merely typify possible variations. Portions and features of some embodiments may be included in, or substituted for, those of others. Many other embodiments will be apparent to those of skill in the art upon reading and understanding the above description.

The Abstract is provided to allow the reader to ascertain the nature and gist of the technical disclosure. It is submitted with the understanding that it will not be used to limit or interpret the scope or meaning of the claims. The following claims are hereby incorporated into the detailed description, with each claim standing on its own as a separate embodiment.

## Claims

1. An apparatus comprising:
a first delay line of a delay-locked loop (DLL) circuitry including an input node to receive an input clock signal and delay stages coupled in series with the input node;
a multiplexer including input nodes coupled to output nodes of a portion of the delay stages; and
a second delay line of the DLL circuitry including an input node coupled to an output node of the multiplexer, and delay stages coupled in series with the input node of the second delay line, the second delay line including an output node to provide an output clock signal.

2. The apparatus of claim 1, wherein the DLL circuitry includes an additional multiplexer, the additional multiplexer including:
a first input node coupled to a clock node;
a second input node coupled to a frequency divider; and
an output node coupled to the input node of the first delay line.

3. The apparatus of claim 2, wherein the additional multiplexer is a first additional multiplexer, and the DLL circuitry includes a circuit, the circuit including a phase frequency detector, the phase frequency detector including:
a first input node coupled to the input node of the first delay line;
a second input node coupled to an output node of the second delay line through a second additional multiplexer; and
an output node coupled to a control input node of the first delay line.

4. The apparatus of claim 3, wherein the DLL circuitry includes an additional circuit, the additional circuit including:
an input node coupled to the clock node; and
an output node coupled to a control input node of the second delay line.

5. The apparatus of any one of claims 3 or 4, further comprising clock distribution circuitry, including:
an input node coupled to the output node of the second delay line; and
an output node coupled to an input node of the second additional multiplexer.

6. The apparatus of any one of claims 1 to 5, wherein a delay stage of the delay stages of the first delay line includes first transistors of a first transistor type, and second transistors of a second transistor type coupled to the first transistors, and wherein:
the DLL circuitry includes a bias circuit coupled to a gate of a transistor of the first transistors and a gate of a transistor of the second transistors.

7. The apparatus of claim 6, wherein a delay stage of the delay stages of the second delay line includes first additional transistors of the first transistor type, and second additional transistors of the second transistor type coupled to the first additional transistors, and wherein:
the DLL circuitry includes an additional bias circuit coupled to a gate of a transistor of the first additional transistors and a gate of a transistor of the second additional transistors.

8. The apparatus of any one of claims 1 to 7, wherein the apparatus comprises a system on chip (SoC), the SoC including an integrated circuit (IC) die, and wherein the DLL circuitry is included in the IC die.

9. The apparatus of any one of claims 1 to 8, further comprising a connector and an integrated circuit (IC) die coupled to the connector, the IC die including the DLL circuitry, wherein the connector conforms with at least one of Universal Serial Bus (USB), High-Definition Multimedia Interface (HDMI), Thunderbolt, Peripheral Component Interconnect Express (PCIe), and Ethernet specifications.

10. A method comprising:
receiving a first clock signal at a device;
providing an input clock signal, based on the first clock signal, to a first delay-locked loop (DLL) circuitry;
generating a second clock signal using multiple delay lines of the DLL circuitry and clock distribution circuitry of the device; and
controlling the DLL circuitry to synchronize the first clock signal and the second clock signal.

11. The method of claim 10, wherein generating the second clock signal includes:
selecting a selected clock signal from multiple output nodes of first delay stages of a first delay line of multiple delay lines;
providing the selected clock signal to a second delay line of the multiple delay lines to generate an output clock signal based on the selected clock signal; and
providing the output clock signal to the clock distribution circuitry to generate the second clock signal based on the output clock signal.

12. The method of claim 11, wherein controlling the DLL circuitry includes:
comparing the input clock signal and a feedback clock signal in a first mode of the DLL circuitry, wherein the feedback clock signal is based on the output clock signal; and
comparing the input clock signal and the feedback clock signal in a second mode of the DLL circuitry, wherein the feedback clock signal is based on the output clock signal.
